# EUROPÄISCHE PATENTSCHRIFT

(11) **EP 2 268 170 B1**
(45) Veröffentlichungstag und Bekanntmachung des Hinweises auf die Patenterteilung: **10.08.2011**
(21) Anmeldenummer: 09728200.8
(22) Anmeldetag: 03.03.2009
(51) Int. Cl.: A47B 88/04, H03K 17/945

(54) **VERFAHREN ZUR STEUERUNG VON MÖBELANTRIEBSEINHEITEN UND STEUERUNGSVORRICHTUNG**
METHOD FOR CONTROLLING FURNITURE DRIVE UNITS AND A CONTROL APPARATUS
PROCÉDÉ DE COMMANDE D UNITÉS D ENTRAÎNEMENT DE MEUBLE ET DISPOSITIF DE COMMANDE

(30) Priorität: 31.03.2008 DE 102008016586
(43) Veröffentlichungstag der Anmeldung: 05.01.2011
(73) Patentinhaber: Paul Hettich GmbH & Co. KG, 32278 Kirchlengern (DE)
(72) Erfinder: BEHNKE, Thomas, 32257 Bünde (DE); FRANKE, Thomas, 32257 Bünde (DE)
(74) Vertreter: Dantz, Jan Henning
(86) Internationale Anmeldenummer: PCT/EP2009/052505
(87) Internationale Veröffentlichungsnummer: WO 2009/121676

(56) Entgegenhaltungen:
- WO-A-2007/009133
- WO-A-2008/031748
- DE-A1- 10 159 336

## Beschreibung

Die vorliegende Erfindung betrifft ein Verfahren zur Steuerung von Möbelantriebseinheiten gemäß dem Oberbegriff des Anspruchs 1 sowie eine Steuerungsvorrichtung zur Steuerung von Möbelantriebseinheiten gemäß dem Oberbegriff des Anspruchs 17.

Möbelantriebseinheiten und Verfahren zu deren Steuerung sind aus dem Stand der Technik bekannt. Solche Möbelantriebseinheiten finden beispielsweise Verwendung in elektromechanischen Schubkastenöffnungssystem, welche typischerweise hinter jedem Schubkasten so positioniert werden, dass der Antrieb, beispielsweise ein motorisch angetriebener Hebel, nach einem entsprechenden Auslösesignal den Schubkasten ein stückweit aus einem Möbelkorpus heraus stößt.

Problematisch ist, dass eine elektronische Steuerung gelegentlich fälschlicherweise ein Auslösesignal zu erkennen glaubt und daraufhin die von der elektronischen Steuerung gesteuerte Antriebseinheit in Gang setzt, obwohl die Betätigung des Schubkastenöffnungssystems nicht beabsichtigt war. Die Ursache einer solchen unbeabsichtigten Auslösung liegt beispielsweise darin, dass eine Erschütterung des Möbelkorpus durch eine äußerliche Krafteinwirkung oder durch Betätigung eines anderen in dem Möbelkorpus befestigten Schubkasten die Auslösung eines Auslösesignals bewirkt.

Dieses Problem wird bisher dadurch gelöst, dass eine elektronische Einheit, die das Auslösesignal an eine elektronische Steuerung weitergibt, möglichst starr und erschütterungssicher an der Rückwand eines Möbelkorpus befestigt wird. Dies ist jedoch insofern nachteilig, als die erschütterungsfreie Befestigung mit einem erhöhten Konstruktionsaufwand und damit erhöhten Kosten verbunden ist.

Eine weitere Lösung besteht darin, dass wenn eine von mehreren Antriebseinheiten in Betrieb ist, diese die anderen Antriebseinheiten sperrt.

Druckschrift WO2007009133 offenbart ein Verfahren zur Steuerung von Möbelantried einheiten nach dem Stand der Technik.

Aufgabe der vorliegenden Erfindung ist es, ein Verfahren zur Steuerung von Möbelantriebseinheiten bereit zu stellen, bei dem eine unbeabsichtigte oder zufällige Auslösung einer Antriebseinheit verhindert wird.

Weitere Aufgabe der Erfindung ist es, eine Steuerungsvorrichtung zur Steuerung von Möbelantriebseinheiten bereitzustellen, bei dem die Möbelantriebseinheiten nicht unbeabsichtigt oder zufällig auslösbar sind.

Diese Aufgaben werden durch ein Verfahren zur Steuerung von Möbelantriebseinheiten gemäß dem kennzeichnenden Teil des Anspruchs 1 sowie durch eine Steuerungsvorrichtung zur Steuerung von Möbelantriebseinheiten gemäß dem kennzeichnenden Teil des Anspruchs 17 gelöst.

Mit dem erfindungsgemäßen Verfahren wird durch die Definition eines Zeitfensters und einem innerhalb dieses Zeitfensters ermittelten Empfindlichkeitsschwellwerts eine Auslösung eines Ausstoßvorgangs von unterschiedlichen Parametern abhängig gemacht und damit eine unbeabsichtigte Auslösung einer Möbelantriebseinheit wirksam verhindert.

Weitere vorteilhafte Ausbildungen der Erfindung sind in den Unteransprüchen gekennzeichnet.

Durch die Zusammenschaltung mehrerer elektronischer Steuereinheiten über einen Datenbus ist ermöglicht, dass der Betrieb einer oder mehrerer Antriebseinheiten sich auf den Empfindlichkeitsschwellwert zur Auslösung einer weiteren Antriebseinheit auswirkt.

Durch den Anschluss weiterer elektronischer Einheiten an den Datenbus ist beispielsweise ein Anschluss von Temperatur, Feuchtigkeits- oder Erschütterungssensoren möglich, wobei die aus diesen elektronischen Einheiten übermittelten Informationen sich auf den Empfindlichkeitsschwellwert auswirken.

Der Vorteil dieser Lösung liegt darin, dass die an den Datenbus angeschlossenen Einheiten auch diverse andere Informationen austauschen können, wie z.B. die Steuerung einer Synchronauslösung von zwei oder mehr Antriebseinheiten. Auch ein Anschluss von Zusatzgeräten wie z.B. zusätzlichen Messeinrichtungen (ohne Antriebseinheit) ist so problemlos möglich. Auch könnten über weitere Sensoren Informationen über Umweltbedingungen (Temperatur, Feuchte, Erdbeben) in die Datenleitung eingespeist werden. Die angeschlossenen Antriebseinheiten können danach ihr Verhalten aktiv anpassen.

Im Umkehrschluss ist aber auch eine Signalauskopplung möglich, so dass alle Businformationen an andere Systeme übergeben werden können.

Ein herkömmlicher Datenbus ist prinzipiell einsetzbar, hat aber den Nachteil, dass immer ein kleiner Zeitversatz durch die serielle Datenübertragung entsteht. Eine vorteilhafte Ausführung der Busübertragung vermeidet diesen Zeitversatz durch die Verwendung des Arbitrationsprinzips. Steuereinheiten mit gleicher Busadresse arbeiten stets gleichzeitig als Informationsgeber und Informationsempfänger. Alle diese Steuereinheiten melden den Status in dem gleichen Zeitsegment und lesen dieses auch gleichzeitig. Sobald eine der Steuereinheiten einen Status setzt, werten alle weiteren Geräte dies aus und können entsprechend zeitsynchron reagieren.

Nachfolgend werden Ausführungsbeispiele anhand der beigefügten Zeichnungen beschrieben. Es zeigen:
- Figur 1: eine perspektivische schematische Ansicht eines Möbels mit Schubkäs- ten als bewegliche Möbelteile
- Figur 2: eine perspektivische Detailansicht eines teilweise auseinander genom- menen Möbels mit einer Möbelantriebseinheit und einem von dieser angetriebenen beweglichen Möbelteil,
- Figur 3: eine schematische Darstellung mehrerer durch eine Busverbindung verbundene Möbelantriebseinheiten,
- Figur 4: ein Diagramm zur Darstellung eine Zeitfensters mit Statusinformatio- nen zur Bestimmung eines Empfindlichkeitsschwellwertes und
- Figur 5: ein Diagramm zur Darstellung eine Zeitfensters mit Statusinformatio- nen zur Bestimmung eines Empfindlichkeitsschwellwertes.

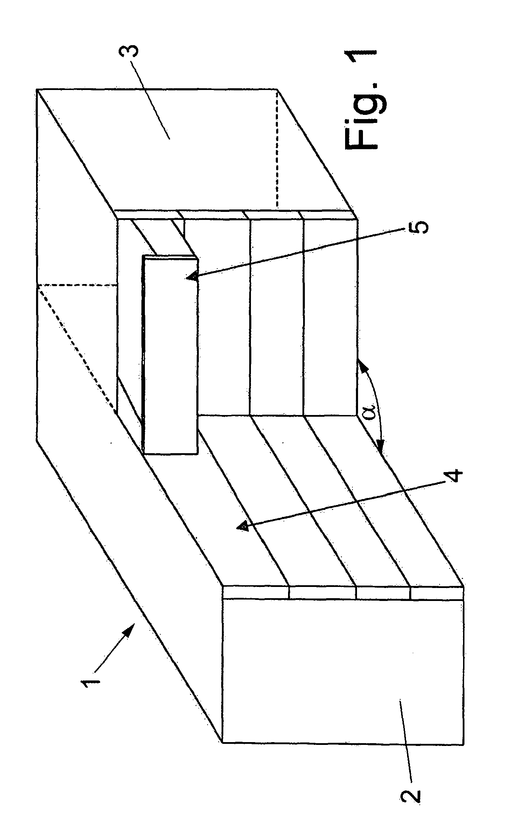

Das erfindungsgemäße Verfahren wird beispielsweise in einem in Figur 1 gezeigtem Möbel eingesetzt. Dieses besteht aus zwei unter einem Winkel α zueinander angeordneten Möbelkorpores 2, 3, in denen bewegliche Möbelteile 4, 5, hier als Schubkästen ausgebildet, gehaltert sind. α beschreibt dabei einen Winkel, der von den Frontseiten zweier Möbelkorpores 2, 3 eingeschlossen wird, aus denen Schubkästen heraus fahrbar, Klappen ausklappbar oder Türen aus der Frontebene heraus schwenkbar angeordnet sind. Auch Kombinationen von Schubkästen, Klappen oder Türen an den Frontseiten der Möbelkorpores 2, 3 sind denkbar.

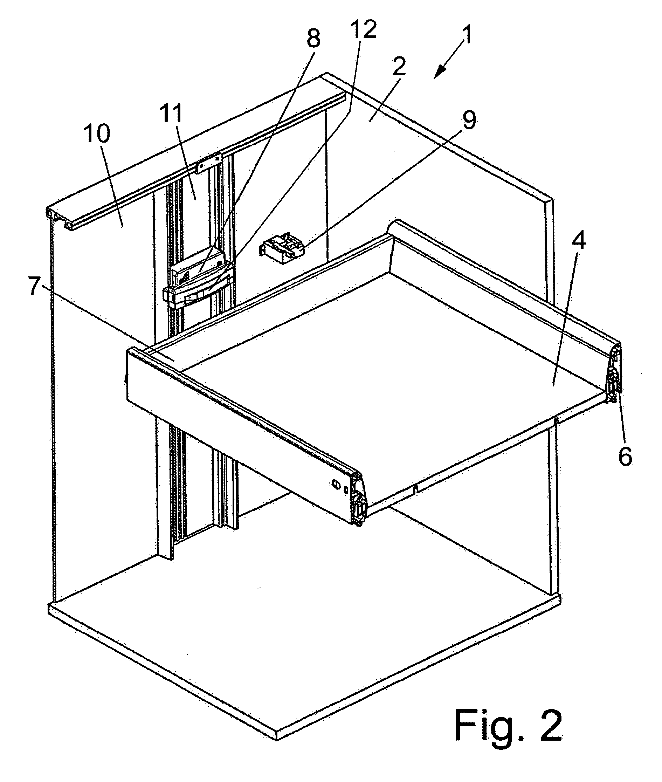

Figur 2 zeigt ein teilweise auseinander genommenes Möbel 1 mit einem darin gehalterten beweglichen Möbelteil. An einem kastenförmigen Möbelkorpus 2 ist ein Schubkasten 4 verschiebbar gehalten. Hierfür sind seitlich an dem Schubkasten 4 Ausziehführungen 6 vorgesehen, die an der jeweiligen Seite am Möbelkorpus 2 festgelegt sind.

Benachbart zu einer Rückwand 7 des Schubkastens 4 ist eine Antriebseinheit 8 mit einem Ausstoßelement 12 und einer elektronischen Steuereinheit zur Steuerung der Antriebseinheit 8 vorgesehen. Das Ausstoßelement 12 ist bevorzugt als Ausstoßhebel oder Ausstoßstößel ausgebildet und wird bevorzugt von einem in der Antriebseinheit 8 untergebrachten Elektromotor angetrieben. Die Antriebseinheit 8 ist an einer vertikalen Leiste 11 gehalten, an der elektrische Leitungen zur Stromversorgung (nicht gezeigt) und eine Datenbus-Leitung (nicht gezeigt) geführt sind.

Mithilfe der Antriebseinheit 8 wird das an dem Möbelkorpus 2 beweglich gehaltene Möbelteil 4 im Normalbetrieb nach dem Übertragen eines Ausstoßsignals an die elektronische Steuereinheit zumindest teilweise aus dem Möbelkorpus 2 durch das Ausstoßelement 12 herausgestoßen, wobei das Ausstoßelement 12 nach dem Ausstoßvorgang wieder in seine Ausgangsstellung zurückgefahren wird.

Das Ausstoßsignal wird von einem Sensor 9 ausgelöst. Der Sensor 9 ist bevorzugt als Positionssensor, beispielsweise als kapazitiver Sensor, oder als berührungsloser Sensor, zum Beispiel als Infrarot-, Ultraschall- oder Funksensor ausgebildet.

Der Sensor 9 reagiert auf eine Positionsänderung eines beweglichen Möbelteils 4 mit dem Aussenden des Ausstoßsignals S_{A}, welche gewöhnlich durch Drücken oder Ziehen eines Benutzers gegen eine bzw. an einer Vorderseite des beweglichen Möbelteils 4 verursacht wird. Bevorzugt ist der Sensor 9 geeignet, die Stärke bzw. den Wert des Ausstoßsignals S_{A} dem Maß der Positionsänderung entsprechend anzupassen.

Eine Positionsänderung des beweglichen Möbelteils 4, 5 gegenüber dem Positionssensor 9 kann aber auch durch eine Erschütterung des beweglichen Möbelteils 4, 5 oder des Sensors 9 selbst ausgelöst werden.

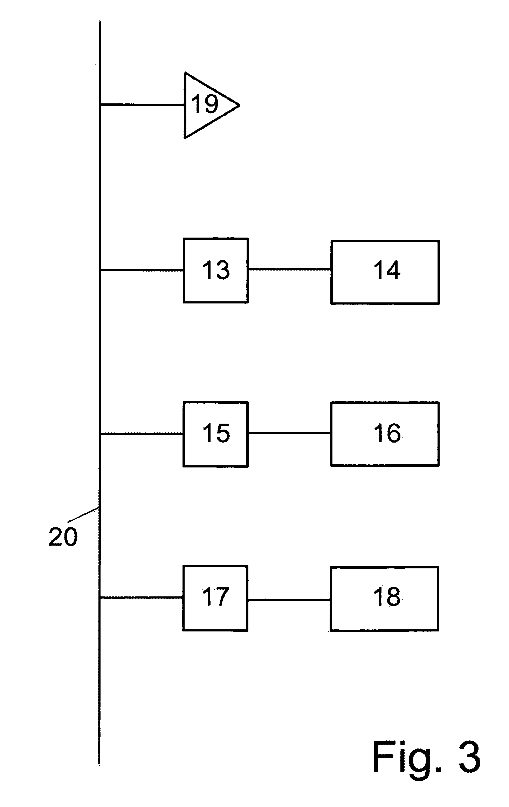

Zur Vermeidung eines solchen unbeabsichtigt verursachten Ausstoßvorgangs dient das erfindungsgemäße Verfahren, das im Folgenden unter Bezugnahme auf die Figuren 3 bis 5 erläutert wird.

Die erfolgreiche Auslösung eines von der Antriebseinheit 14 durchzuführenden Ausstoßvorgangs hängt bei dem erfindungsgemäßen Verfahren von der Überschreitung des Ausstoßsignals S_{A} über einen in einem Verfahrensschritt zu bestimmenden Empfindlichkeitsschwellwert E_{S} ab. Die Bestimmung dieses Empfindlichkeitsschwellwerts E_{S} erfolgt erfindungsgemäß innerhalb eines Zeitfensters F, das durch einen Taktgeber definiert wird. Zur Bestimmung des Empfindlichkeitsschwellwerts E_{S} werden von der elektronischen Steuereinheit 13, 15, 17 Statusinformationen I₂, I₃, I₄, über den Status der ihr zugeordneten Antriebseinheit 14, 16, 18 abgerufen und in der elektronischen Steuereinheit 13, 15, 17 ausgewertet. Bevorzugt sind bei Möbeln 1, in denen mehrere Antriebseinheiten 14, 16, 18 Verwendung finden, die elektronischen Steuereinheiten 13, 15, 17 der Antriebseinheiten 14, 16, 18 über einen Datenbus 20 vernetzt. Dann werden zur Bestimmung des Empfindlichkeitsschwellwerts E_{S} die Statusinformationen I₂, I₃, I₄, über den aktuellen Zustand aller Antriebseinheiten 14, 16, 18 herangezogen.

Besonders bevorzugt ist an den Datenbus 20 mindestens eine weitere Statusinformationen liefernde elektronische Einheit 19 angeschlossen, deren Statusinformationen ebenfalls bei der Bestimmung des Empfindlichkeitsschwellwerts E_{S} berücksichtigt werden.

Innerhalb des Zeitfensters F werden zunächst die Informationen aller angeschlossenen elektronischen Einheiten 13, 15, 17,19 gelesen und die eigenen Informationen an alle anderen elektronischen Einheiten gesendet. In der Restzeit des Zeitfensters F wird aus den gesamten innerhalb des Zeitfensters F vorhandenen Informationen I₂, I₃, I₄ der Empfindlichkeitsschwellwerts E_{S} berechnet.

Die Statusinformationen der Antriebseinheiten 14, 16, 18 bestehen beispielsweise aus einer Information über die Betriebsbereitschaft einer Antriebseinheit 14, 16, 18, einer Fehlermeldung, ob die Antriebseinheit 14, 16, 18 im Eingriff mit einem beweglichen Möbelteil 4, 5 steht oder nicht oder ob eine der Antriebseinheiten 14, 16, 18 gerade einen Ausstoßvorgang durchführt. Statusinformationen einer weiteren elektronischen Einheit 19 sind zum Beispiel die Meldung einer Erschütterung des beweglichen Möbelteils 4, 5 oder eine Information über eine Umgebungstemperatur oder Umgebungsfeuchte.

Je nachdem, welche Statusinformationen innerhalb des Zeitfensters F aufeinandertreffen, errechnet die elektronische Steuereinheit 13, 15, 17 die den Ausstoßvorgang der Antriebseinheit 14, 16, 18 steuern soll, einen entsprechend hohen oder niedrigen Empfindlichkeitsschwellwert E_{S}. Überschreitet der Wert des Ausstoßsignals S_{A} diesen Empfindlichkeitsschwellwert E_{S}, führt die Antriebseinheit 14, 16, 18 den Ausstoßvorgang durch, liegt der Wert des Ausstoßsignals S_{A} unter dem Empfindlichkeitsschwellwert E_{S}, ignoriert die Antriebseinheit 14, 16, 18 den Ausstoßvorgang.

Der Ablauf des Verfahrens läuft bevorzugt wie folgt ab: Zunächst findet ein kontinuierlicher Austausch aktueller Statusinformationen der mindestens einen Antriebseinheit 14, 16, 18 zwischen der Antriebseinheit 14, 16, 18 und der elektronischen Steuereinheit 13, 15, 17 in durch ein Zeitfenster F definierten Zeitabständen statt. Tritt in einem solchen Zeitfenster F ein Ausstoßsignals S_{A} auf, wird am Ende dieses Zeitfensters ein Empfindlichkeitsschwellwert E_{S} aus den der elektronischen Steuereinheit 13, 15, 17 innerhalb dieses Zeitfensters F zur Verfügung stehenden Statusinformationen I₂, I₃, I₄, I₇, I₈, I₉ bestimmt. Anschließend wird dieser Empfindlichkeitsschwellwert E_{S} mit dem Wert des Ausstoßsignals S_{A} verglichen. Je nach Resultat des Vergleichs wird ein Ausstoßvorgang durchgeführt, falls das Ausstoßsignal (S_{A}) den Empfindlichkeitsschwellwert (E_{S}) überschreitet oder das Ausstoßsignal S_{A} wird ignoriert, falls das Ausstoßsignal (S_{A}) den Empfindlichkeitsschwellwert (E_{S}) unterschreitet.

Mit dem erfindungsgemäßen Verfahren können weitreichende Funktionskoordinationen durchgeführt werden. Bevorzugt kann sich z.B. jede Antriebseinheit 14, 16, 18 individuell auf die Umgebungssituation einstellen, da die aktuellen Zustände von allen anderen am Datenbus 20 angeschlossenen Antriebseinheiten 14, 16, 18 jederzeit bekannt sind. Damit ist es beispielsweise denkbar, dass eine Antriebseinheit 14, 16, 18 die Empfindlichkeit des eingebauten Auslösesensors 9 in Abhängigkeit von der Anzahl der momentan aktiven Antriebseinheiten 14, 16, 18 stufenweise reduziert bis hin zur völligen Unempfindlichkeit des Auslösesensors 9. Damit wird zeitweise eine größere Störunempfindlichkeit erreicht, die jedoch die gewollte Aktivierung dieser Möbeleinheit 4, 5 durch den Anwender weiterhin ermöglicht

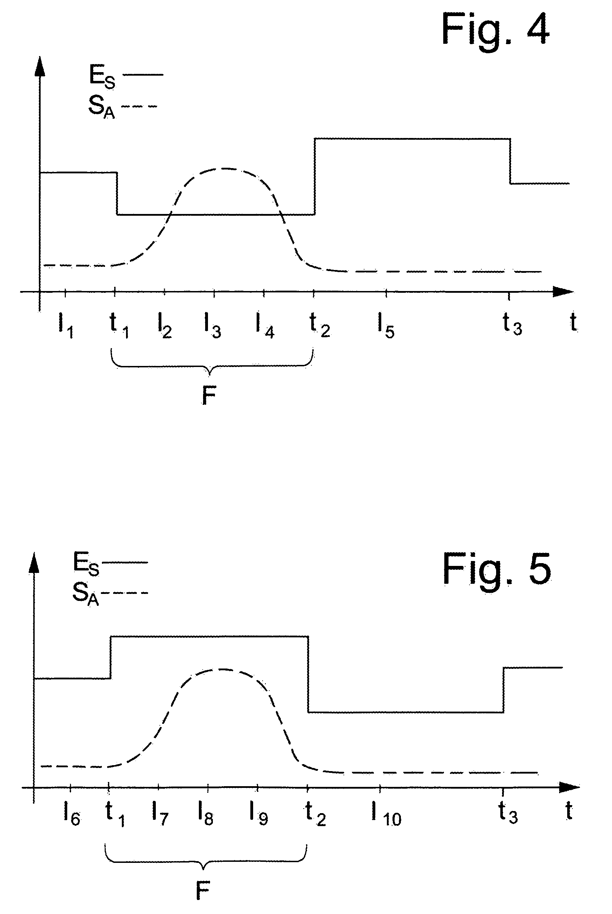

Die Figuren 4 und 5 zeigen Beispiele für je ein erfolgreiches Ausstoßsignal und ein ignoriertes Ausstoßsignal unter Verwendung des erfindungsgemäßen Verfahrens. Beide Figuren zeigen ein Zeitfenster F, in dem unterschiedliche Statusinformationen I₂, I₃, I₄, I₇, I₈, I₉ innerhalb des Zeitfensters von der elektronischen Steuereinheit 13, 15, 17 abgerufen werden, an die das Ausstoßsignal gesendet wurde. Die Statusinformationen I₁, I₅ bzw. I₆, I₁₀ liegen außerhalb des jeweiligen Zeitfensters F und werden somit nicht mit erfasst.

Betrifft das in Figur 4 gezeigte Diagramm beispielsweise ein an die Antriebseinheit 14 gesendetes Ausstoßsignal und wird der zugehörigen elektronischen Steuereinheit 13 über die abgerufenen Statusinformationen I₂, I₃, I₄ beispielsweise mitgeteilt, dass die Antriebseinheit 14 betriebsbereit ist, einen Schubkasten 4 im Eingriff hat und Antriebseinheit 16 gerade einen Ausstoßvorgang durchführt, errechnet die elektronische Steuereinheit 13 unter Zuhilfenahme dieser Statusinformationen I₂, I₃, I₄ einen Empfindlichkeitsschwellwert E_{S}, der unter dem Wert des von dem Sender abgegebenen Ausstoßsignals S_{A} liegt. Daraufhin weist die elektronischen Steuereinheit 13 die Antriebseinheit 14 an, den Ausstoßvorgang durchzuführen.

Betrifft das in Figur 5 gezeigte Diagramm beispielsweise ein an die Antriebseinheit 14 gesendetes Ausstoßsignal und wird der zugehörigen elektronischen Steuereinheit 13 über die abgerufenen Statusinformationen I₇, I₈, I₉ beispielsweise mitgeteilt, dass die Antriebseinheit 14 betriebsbereit ist, einen Schubkasten 4 im Eingriff hat und Antriebseinheit 16 gerade einen Ausstoßvorgang durchführt, welche einen Schubkasten 5 antreibt, der nicht gleichzeitig mit dem von der Antriebseinheit 14 angetriebenen Schubkasten 4 herausfahrbar ist, errechnet die elektronische Steuereinheit 13 unter Zuhilfenahme dieser Statusinformationen I₇, I₈, I₉ einen Empfindlichkeitsschwellwert E_{S}, der über dem Wert des von dem Sender abgegebenen Ausstoßsignals S_{A} liegt. Daraufhin ignoriert die elektronischen Steuereinheit 13 das an die Antriebseinheit 14 gesendetes Ausstoßsignal, so dass der Ausstoßvorgang nicht durchgeführt wird.

In einer vorteilhaften Ausführungsform des erfindungsgemäßen Verfahrens lassen sich alle über den Datenbus 20 ausgetauschten Statusinformationen I₁, I₂, I₃, I₄, I₅, I₆, I₇, I₈, I₉, I₁₀ an ein externes System übertragen. Dies ist insbesondere bei übereck stehenden Möbelanordnungen vorteilhaft, um auf diese Weise die Funktionen mehrerer über mehrere Datenbussysteme verbundene elektronische Einheiten aufeinander abzustimmen.

Bevorzugt wird jeder Antriebseinheit 14, 16, 18 eine von allen elektronischen Steuereinheiten erkennbare Steueradresse zugewiesen. Die Datenübertragung über den Datenbus erfolgt bei dieser Ausführungsform in serieller Weise.

In einer alternativen bevorzugten Ausführungsform des erfindungsgemäßen Verfahrens wird mindestens zweien der Antriebseinheiten 14, 16, 18 die gleiche Steueradresse zugewiesen. Hier erfolgt die Datenübertragung besonders bevorzugt unter Verwendung des Arbitrationsprinzips. Geräte mit gleicher Busadresse arbeiten stets gleichzeitig als Informationsgeber und Informationsempfänger. Alle diese Geräte melden den Status in dem gleichen Zeitsegment und lesen dieses auch gleichzeitig. Dadurch können alle an den Datenbus angeschlossenen Einheiten (13, 15, 17, 19) zeitsynchron reagieren.

### Bezugszeichenliste

- 1: Möbel
- 2: Möbelkorpus
- 3: Möbelkorpus
- 4: Schubkasten
- 5: Schubkasten
- 6: Ausziehführung
- 7: Rückwand
- 8: Antriebseinheit
- 9: Sensor
- 10: Rückwand
- 11: Leiste
- 12: Ausstoßelement
- 13: elektronische Steuereinheit
- 14: Antriebseinheit
- 15: elektronische Steuereinheit
- 16: Antriebseinheit
- 17: elektronische Steuereinheit
- 18: Antriebseinheit
- 19: elektronische Einheit
- 20: Datenbus
- E: Empfindlichkeit
- E_{S}: Empfindlichkeitsschwellwert
- S_{A}: Ausstoßsignal
- F: Zeitfenster
- t: Zeit
- t₁: Beginn eines Zeitfensters
- t₂: Ende eines Zeitfensters
- I₁: Statusinformation 1
- I₂: Statusinformation 2
- I₃: Statusinformation 3
- I₄: Statusinformation 4
- I₅: Statusinformation 5
- I₆: Statusinformation 6
- I₇: Statusinformation 7
- I₈: Statusinformation 8
- I₉: Statusinformation 9
- I₁₀: Statusinformation 10

## Patentansprüche

1. Verfahren zur Steuerung mindestens einer Antriebseinheit (14, 16, 18) mittels einer elektronischen Steuereinheit (13, 15, 17), die mindestens ein relativ zu einem Möbelkorpus (2, 3) bewegliches Möbelteil (4, 5) antreibt, **dadurch gekennzeichnet, dass** das Verfahren die folgenden Schritte aufweist:
a) Regelmäßige Abfrage aktueller Statusinformationen der Antriebseinheit (14, 16, 18) durch die elektronische Steuereinheit (13, 15, 17) in durch ein Zeitfenster (F) definierten Zeitabständen,
b) Regelmäßige Bestimmung eines Empfindlichkeitsschwellwerts (Es) aus den der elektronischen Steuereinheit (13, 15, 17) innerhalb dieses Zeitfensters (F) zur Verfügung stehenden Statusinformationen (I₂, I₃, I₄, I₇, I₈, I₉),
c) Erzeugen eines Ausstoßsignals (S_{A}) in einem Zeitfenster (F).
d) Vergleich des Empfindlichkeitsschwellwert (E_{S}) mit dem Wert des Ausstoßsignals (S_{A}),
e) Durchführung des Ausstoßvorgangs, falls das Ausstoßsignal (S_{A}) den Empfindlichkeitsschwellwert (E_{S}) überschreitet oder
f) Ignorieren des Ausstoßsignals (S_{A}), falls das Ausstoßsignal (S_{A}) den Empfindlichkeitsschwellwert (E_{S}) unterschreitet.

2. Verfahren nach Anspruch 1, **dadurch gekennzeichnet, dass** die Durchführung eines Ausstoßvorgangs eine Änderung einer Statusinformation (I₁, I₂, I₃, I₄, I₅, I₆, I₇, I₈, I₉, I₁₀,) bewirkt.

3. Verfahren nach Anspruch 1 oder 2, **dadurch gekennzeichnet, dass** ein innerhalb des Zeitfensters (F) erfasster Ausstoßvorgang die Heraufsetzung des Empfindlichkeitsschwellwerts (Es) bewirkt.

4. Verfahren nach einem der vorstehenden Ansprüche, **dadurch gekennzeichnet, dass** ein durchgeführter Ausstoßvorgang eine Änderung einer Statusinformation (I₁, I₂, I₃, I₄, I₅, I₆, I₇, I₈, I₉, I₁₀,) bewirkt.

5. Verfahren nach einem der vorstehenden Ansprüche, **dadurch gekennzeichnet, dass** ein innerhalb des Zeitfensters (F) erfasster beendeter Ausstoßvorgang die Herabsetzung des Empfindlichkeitsschwellwerts (E_{S}) bewirkt.

6. Verfahren nach einem der vorstehenden Ansprüche, **dadurch gekennzeichnet, dass** ein innerhalb des Zeitfensters (F) erfasster Eingriff der Antriebseinheit mit einem beweglichen Möbelteil als Statusinformation die Herabsetzung des Empfindlichkeitsschwellwerts (E_{S}) bewirkt.

7. Verfahren nach einem der vorstehenden Ansprüche, **dadurch gekennzeichnet, dass** eine innerhalb des Zeitfensters (F) erfasste Betriebsbereitschaft der Antriebseinheit als Statusinformation die Herabsetzung des Empfindlichkeitsschwellwerts (E_{S}) bewirkt.

8. Verfahren nach einem der vorstehenden Ansprüche, **dadurch gekennzeichnet, dass** jede Möbelantriebseinheit (14, 16, 18) von einer separaten elektronischen Steuereinheit (13, 15, 17) gesteuert wird.

9. Verfahren nach Anspruch 8, **dadurch gekennzeichnet, dass** die elektronischen Steuereinheiten (13, 15, 17) über einen Datenbus (20) miteinander verbunden sind.

10. Verfahren nach Anspruch 9, **dadurch gekennzeichnet, dass** an den Datenbus (20) mindestens eine weitere Statusinformationen (I₁, I₂, I₃, I₄, I₅, I₆, I₇, I₈, I₉, I₁₀,) liefernde elektronische Einheit (19) angeschlossen ist.

11. Verfahren nach Anspruch 10, **dadurch gekennzeichnet, dass** die weitere elektronische Einheit (19) Statusinformationen (I₁, I₂, I₃, I₄, I₅, I₆, I₇, I₈, I₉, I₁₀,) über eine Umgebungstemperatur, -feuchte oder einer Erschütterung bereitstellt.

12. Verfahren nach einem der vorstehenden Ansprüche, **dadurch gekennzeichnet, dass** jeder Antriebseinheit (14, 16, 18) eine Steueradresse zugewiesen wird und die Auslösung eines weiteren Ausstoßsignals (S_{A}) die Öffnung eines zweiten Zeitfensters (F) bewirkt.

13. Verfahren nach Anspruch 12, **dadurch gekennzeichnet, dass** mindestens zwei Antriebseinheiten (14, 16, 18) die gleiche Steueradresse zugewiesen wird.

14. Verfahren nach einem der Ansprüche 9 bis 13, **dadurch gekennzeichnet, dass** alle über den Datenbus (20) ausgetauschten Statusinformationen (I₁, I₂, I₃, I₄, I₅, I₆, I₇, I₈, I₉, I₁₀,) an ein externes System übertragen werden.

15. Verfahren nach einem der Ansprüche 9 bis 14, **dadurch gekennzeichnet, dass** die Datenübertragung über den Datenbus (20) seriell erfolgt.

16. Verfahren nach einem der Ansprüche 9 bis 14, **dadurch gekennzeichnet, dass** die Datenübertragung über den Datenbus (20) nach dem Arbitrationsprinzip erfolgt.

17. Steuerungsvorrichtung zur Steuerung von Möbelantriebseinheiten mit mindestens einer elektronischen Steuereinheit (13, 15, 17) zur Steuerung mindestens einer Antriebseinheit (14, 16, 18), die mindestens ein relativ zu einem Möbelkorpus (2, 3) bewegliches Möbelteil antreibt, **dadurch gekennzeichnet, dass** die elektronische Steuereinheit (13, 15, 17) ein Verfahren zur Steuerung der mindestens einen Antriebseinheit (14, 16, 18) mittels der elektronischen Steuereinheit (13, 15, 17) nach einem der vorhergehenden Ansprüche verwendet.

## Claims

1. Method for controlling at least one drive unit (14, 16, 18) by means of an electronic control unit (13, 15, 17) which drives at least one furniture part (4, 5), which can move relative to a furniture body (2, 3), **characterized in that** the method has the following steps:
a) regular checking of current status information of the drive unit (14, 16, 18) by the electronic control unit (13, 15, 17) at time intervals which are defined by a time window (F),
b) regular determination of a sensitivity threshold value (E_{S}) from the status information (I₂, I₃, I₄, I₇, I₈, I₉) which is available to the electronic control unit (13, 15, 17) within this time window (F),
c) production of an ejection signal (S_{A}) in a time window (F),
d) comparison of the sensitivity threshold value (E_{S}) with the value of the ejection signal (S_{A}),
e) carrying out the ejection process if the ejection signal (S_{A}) exceeds the sensitivity threshold value (E_{S}), or
f) ignoring the ejection signal (S_{A}) if the ejection signal (S_{A}) is below the sensitivity threshold value (E_{S}).

2. Method according to Claim 1, **characterized in that** an ejection process results in a change in status information (I₁, I₂, I₃, I₄, I₅, I₆, I₇, I₈, I₉, I₁₀).

3. Method according to Claim 1 or 2, **characterized in that** an ejection process which is detected within the time window (F) results in the sensitivity threshold value (E_{S}) being raised.

4. Method according to one of the preceding claims, **characterized in that** an ejection process results in a change in status information (I₁, I₂, I₃, I₄, I₅, I₆, I₇, I₈, I₉, I₁₀).

5. Method according to one of the preceding claims, **characterized in that** the end of an ejection process detected within the time window (F) results in the reduction in the sensitivity threshold value (E_{S}).

6. Method according to one of the preceding claims, **characterized in that** an intervention of the drive unit detected within the time window (F) with a moving furniture part as status information results in the sensitivity threshold value (E_{S}) being reduced.

7. Method according to one of the preceding claims, **characterized in that** operational readiness of the drive unit detected within the time window (F) as status information results in the sensitivity threshold value (E_{S}) being reduced.

8. Method according to one of the preceding claims, **characterized in that** each furniture drive unit (14, 16, 18) is controlled by a separate electronic control unit (13, 15, 17).

9. Method according to Claim 8, **characterized in that** the electronic control units (13, 15, 17) are connected to one another via a data bus (20).

10. Method according to Claim 9, **characterized in that** at least one further electronic unit (19), which produces status information (I₁, I₂, I₃, I₄, I₅, I₆, I₇, I₈, I₉, I₁₀) is connected to the data bus (20).

11. Method according to Claim 10, **characterized in that** the further electronic unit (19) provides status information (I₁, I₂, I₃, I₄, I₅, I₆, I₇, I₈, I₉, I₁₀) relating to an ambient temperature, humidity or vibration.

12. Method according to one of the preceding claims, **characterized in that** each drive unit (14, 16, 18) is assigned a control address, and the initiation of a further ejection signal (S_{A}) results in the opening of a second time window (F).

13. Method according to Claim 12, **characterized in that** at least two drive units (14, 16, 18) are assigned the same control address.

14. Method according to one of Claims 9 to 13, **characterized in that** all of the status information (I₁, I₂, I₃, I₄, I₅, I₆, I₇, I₈, I₉, I₁₀) which is interchanged via the data bus (20) is transmitted to an external system.

15. Method according to one of Claims 9 to 14, **characterized in that** data is transmitted in serial form via the data bus (20).

16. Method according to one of Claims 9 to 14, **characterized in that** data is transmitted via the data bus (20) using the arbitration principle.

17. Control apparatus for controlling furniture drive units by means of at least one electronic control unit (13, 15, 17) for controlling at least one drive unit (14, 16, 18), which drives at least one furniture part, which can move relative to a furniture body (2, 3), **characterized in that** the electronic control unit (13, 15, 17) uses a method for controlling the at least one drive unit (14, 16, 18) by means of the electronic control unit (13, 15, 17) according to one of the preceding claims.

## Revendications

1. Procédé de commande d'au moins une unité d'entraînement (14, 16, 18) au moyen d'une unité de commande électronique (13, 15, 17) qui entraîne au moins une partie de meuble (4, 5) mobile par rapport à un corps de meuble (2, 3), **caractérisé en ce que** le procédé comporte les étapes suivantes consistant à :
a) demander régulièrement des informations d'état actuelles de l'unité d'entraînement (14, 16, 18) par l'unité de commande électronique (13, 15, 17) à des intervalles de temps définis par une fenêtre de temps (F),
b) déterminer régulièrement une valeur de seuil de sensibilité (E_{S}) à partir des informations d'état (I₂, I₃, I₄, I₇, I₈, I₉) disponibles à l'unité de commande électronique (13, 15, 17) à l'intérieur de cette fenêtre de temps (F),
c) générer un signal d'expulsion (SA) dans une fenêtre de temps (F).
d) comparer la valeur de seuil de sensibilité (E_{S}) à la valeur du signal d'expulsion (S_{A}),
e) exécuter l'opération d'expulsion si le signal d'expulsion (S_{A}) devient supérieur à la valeur de seuil de sensibilité (E_{S}) ou
f) ignorer le signal d'expulsion (SA) si le signal d'expulsion (SA) devient inférieur à la valeur de seuil de sensibilité (E_{S}).

2. Procédé selon la revendication 1, **caractérisé en ce que** l'exécution d'une opération d'expulsion provoque un changement d'une information d'état (I₁, I₂, I₃, I₄, I₅, I₆, I₇, I₈, I₉, I₁₀).

3. Procédé selon la revendication 1 ou 2, **caractérisé en ce qu'**une opération d'expulsion détectée à l'intérieur de la fenêtre de temps (F) provoque la majoration de la valeur de seuil de sensibilité (E_{S}).

4. Procédé selon l'une quelconque des revendications précédentes, **caractérisé en ce qu'**une opération d'expulsion exécutée provoque un changement d'une information d'état (I₁, I₂, I₃, I₄, I₅, I₆, I₇, I₈, I₉, I₁₀).

5. Procédé selon l'une quelconque des revendications précédentes, **caractérisé en ce qu'**une opération d'expulsion terminée détectée à l'intérieur de la fenêtre de temps (F) provoque la minoration de la valeur de seuil de sensibilité (E_{S}).

6. Procédé selon l'une quelconque des revendications précédentes, **caractérisé en ce qu'**une intervention de l'unité d'entraînement avec une partie de meuble mobile, détectée à l'intérieur de la fenêtre de temps (F) en tant qu'information d'état, provoque la minoration de la valeur de seuil de sensibilité (Es).

7. Procédé selon l'une quelconque des revendications précédentes, **caractérisé en ce qu'**une disponibilité de fonctionnement de l'unité d'entraînement, détectée à l'intérieur de la fenêtre de temps (F) en tant qu'information d'état, provoque la minoration de la valeur de seuil de sensibilité (Es).

8. Procédé selon l'une quelconque des revendications précédentes, **caractérisé en ce que** chaque unité d'entraînement de meuble (14, 16, 18) est commandée par une unité de commande électronique distincte (13, 15, 17).

9. Procédé selon la revendication 8, **caractérisé en ce que** les unités de commande électroniques (13, 15, 17) sont reliées entre elles par le biais d'un bus de données (20).

10. Procédé selon la revendication 9, **caractérisé en ce qu'**au moins une autre unité électronique (19) délivrant des informations d'état (I₁, I₂, I₃, I₄, I₅, I₆, I₇, I₈, I₉, I₁₀) est raccordée au bus de données (20).

11. Procédé selon la revendication 10, **caractérisé en ce que** l'autre unité électronique (19) met à disposition des informations d'état (I₁, I₂, I₃, I₄, I₅, I₆, I₇, I₈, I₉, I₁₀) sur une température ambiante, une humidité ambiante ou une secousse.

12. Procédé selon l'une quelconque des revendications précédentes, **caractérisé en ce qu'**une adresse de commande est attribuée à chaque unité d'entraînement (14, 16, 18) et le déclenchement d'un autre signal d'expulsion (S_{A}) provoque l'ouverture d'une deuxième fenêtre de temps (F).

13. Procédé selon la revendication 12, **caractérisé en ce que** la même adresse de commande est attribuée à au moins deux unités d'entraînement (14, 16, 18).

14. Procédé selon l'une des revendications 9 à 13, **caractérisé en ce que** toutes les informations d'état (I₁, I₂, I₃, I₄, I₅, I₆, I₇, I₈, I₉, I₁₀) échangées par le biais du bus de données (20) sont transmises à un système externe.

15. Procédé selon l'une des revendications 9 à 14, **caractérisé en ce que** la transmission de données est effectuée en série par le biais du bus de données (20).

16. Procédé selon l'une des revendications 9 à 14, **caractérisé en ce que** la transmission de données est effectuée par le biais du bus de données (20) selon le principe d'arbitrage.

17. Dispositif de commande d'unités d'entraînement de meuble ayant au moins une unité de commande électronique (13, 15, 17) pour commander au moins une unité d'entraînement (14, 16, 18), qui entraîne au moins une partie de meuble mobile par rapport à un corps de meuble (2, 3), **caractérisé en ce que** l'unité de commande électronique (13, 15, 17) emploie un procédé selon l'une quelconque des revendications précédentes pour commander la ou les unités d'entraînement (14, 16, 18) au moyen de l'unité de commande électronique (13, 15, 17).
